# EUROPEAN PATENT APPLICATION

(11) **EP 4 707 827 A1**
(43) Date of publication of application: **11.03.2026**
(21) Application number: 25200528.5
(22) Date of filing: 05.09.2025
(51) Int. Cl.: G01R 31/317, G01R 31/3187

(54) **COMPARATOR BUILT-IN SELF TEST (BIST) CIRCUIT**

(30) Priority: 06.09.2024 IN 202441067691
(71) Applicant: NXP USA, Inc., Austin, TX 78735 (US)
(72) Inventor: SAHU, Siyaram, 5656AG Eindhoven (NL); KINGHAM, Eric Thomas, 5656AG Eindhoven (NL); SINHA, Anand Kumar, 5656AG Eindhoven (NL); OMER, Ateet, 5656AG Eindhoven (NL)
(74) Representative: Hardingham, Christopher Mark

(57) **Abstract**

An integrated circuit includes a comparator (102), a clock generator (110), and control circuitry (250). The comparator (102) has a first input, a second input, and an output configured to provide an output clock. The clock generator (110) is configured to generate a differential periodic signal formed from a first periodic signal and a second periodic signal. The clock generator (110) provides the first periodic signal to the first input of the comparator and the second periodic signal to the second input of the comparator, and the clock generator (110) is configured to vary an amplitude of the differential periodic signal based on a control input. The control circuitry (250) is configured to measure hysteresis of the comparator by providing the control input to the clock generator (110) to incrementally vary the amplitude of the differential periodic signal until detecting a predetermined number of state changes of the output clock.

## Description

### BACKGROUND

### Field

This disclosure relates generally to integrated circuits, and more specifically, to a comparator with a built-in self test (BIST) circuit.

### Related Art

Integrated comparators are commonly used within a system-on-chip (SoC) to generate rail-to-rail clock signals. These comparators typically include a positive feedback component to implement hysteresis to filter the effect of input noise at the output. Speed and hysteresis are two key performance indicators for these comparators used in clock generation applications. To ensure proper functioning, automatic test equipment (ATE) is typically used to test and characterize the comparators. For example, for the hysteresis measurement of a crystal oscillator comparator at ATE characterization, a minimum DC voltage is applied at a comparator input (EXTAL) while keeping the other comparator input (XTAL) at a fixed value. The DC voltage level at the comparator input is increased in a staircase fashion until the output of the comparator toggles from zero to one, indicating the VTH of the comparator, followed by decreasing the DC voltage level at the comparator input until the output of the comparator toggles back to zero. The difference between VTH and VTL indicate the hysteresis of the comparator.

However, this level of characterization is not typically available during production testing. Instead, during production testing, a simple go/no-go test is typically implemented by applying the minimum and maximum input levels of a given hysteresis range for a comparator and observing the comparator output at each of the applied minimum and maximum levels to see if the comparator operates as expected. Therefore, a need exists for improved testing and characterization of comparator hysteresis without the need of external test instruments.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in partial block diagram and partial flow diagram form, a comparator and corresponding BIST circuit, in accordance with one embodiment of the present invention.
FIG. 2 illustrates, in partial block diagram and partial schematic form, a more detailed view of the comparator and corresponding BIST circuit of FIG. 1, in accordance with one embodiment of the present invention.
FIG. 3 illustrates, in schematic form, a differential amplitude-varying clock generator usable within the BIST circuit of FIGs. 1 and 2, in accordance with an embodiment of the present invention.

### DETAILED DESCRIPTION

In one aspect, an SoC (e.g. an integrated circuit) includes a hysteretic comparator (i.e. a comparator with hysteresis) and a corresponding built-in self test (BIST) circuit capable of characterizing and testing the hysteresis of the comparator. In this manner, the comparator can be tested without the need for any external test equipment and can therefore be done at any time, during production testing as well as during in-field operation. In one embodiment, a differential amplitude-varying periodic signal (e.g. clock signal) is applied across the positive and negative comparator inputs, and the response of the comparator is monitored internally by the BIST circuit. To measure the hysteresis of the comparator, a low amplitude generated differential clock is applied to the comparator inputs, in which the amplitude of the generated differential clock is increased over time until the output of the comparator makes a transition. The input amplitude at which the comparator transitions its output indicates the measured hysteresis of the comparator.

In one embodiment, a clock generator generates pairs of clock signals based on an input clock signal, in which the pairs of clock signals correspond to generated differential clock signals at the target frequency with varying amplitudes (i.e. clock swings). In this manner, control circuitry can be used during testing to select from the pairs of clock signals to vary the amplitude of the differential clock at the inputs of the comparator, as needed, in response to monitoring the comparator output. The information logged by the control circuitry can then be used to determine the hysteresis of the comparator.

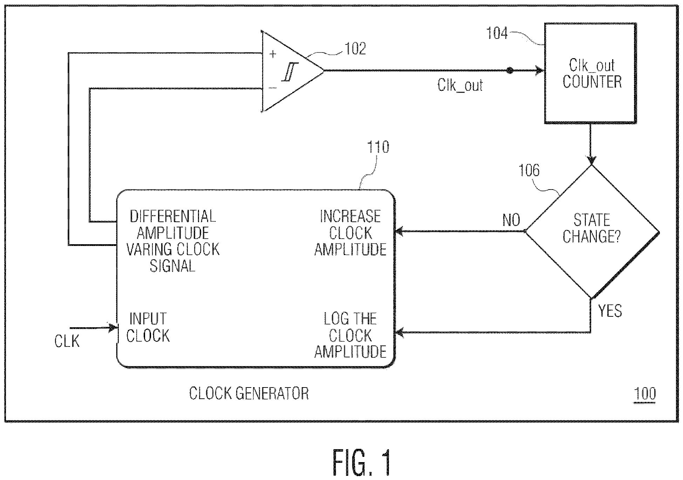

FIG. 1 illustrates, in partial block diagram and partial flow diagram form, a comparator system 100, including a corresponding BIST circuit, in accordance with an embodiment of the present invention. Comparator system 100 may be implemented as part of an SoC and may therefore be referred to as an SoC or an integrated circuit. System 100 includes a comparator 102 with hysteresis (also referred to as a hysteretic comparator), a clk_out counter 104 (also referred to as counter 104), and a clock generation circuit 110 (also referred to as clock generator 110). Clock generator 110 is coupled to receive an input clock (CLK) and generates a differential amplitude-varying clock. As will be described below, the differential amplitude-varying clock can be any differential amplitude-varying periodic signal. An output of comparator 102 is provided as clk_out to an input of counter 104. System 100 also includes digital logic used during testing to monitor counter 104, and in response to the monitoring, provide appropriate information to clock generation circuit 110 to either increase the amplitude of the differential amplitude-varying clock or log the current clock amplitude (or an indication thereof).

Comparator 102 operates with hysteresis, in which the voltage level (e.g. VTH) at which the output of comparator 102 transition from low to high (e.g. zero to one), differs from the voltage level (e.g. VTL) at which the output of comparator 102 transitions from high to low (e.g. one to zero). The hysteresis of comparator 102 is defined as the difference between VTH and VTL (e.g. VTH-VTL). A corresponding BIST circuit of system 100 is used to test and determine the hysteresis of comparator 102. As will be described in more detail below, the surrounding logic in FIG. 1, including counter 104 and clock generator 110, form the corresponding BIST circuit for testing comparator 102. Comparator 102 has a non-inverting input (e.g. a positive or "plus" input) and an inverting input (e.g. a negative of "minus" input). Clock generator 110 provides a differential clock signal (formed by a first clock signal and a second clock signal) to the inputs of comparator 102. That is, the positive input receives the first clock signal from clock generator 110 and the negative input receives the second clock signal from clock generator 110, in which the first and second clock signals form a differential pair about the same common voltage (Vcm). The second clock signal is the same as the first clock signal but shifted 180 degrees with respect to the first clock signal to form the differential pair. Therefore, the output of comparator 102 toggles based on the difference between the first and second clock signals. (Note that the first and second clock signals, as well as the differential clock signal, may be generated using any type of periodic signal and may therefore be referred to as periodic signals rather than clock signals.)

Clock generator 110 is capable of varying the amplitude of the differential signal by varying the amplitudes of the first and second clock signals. Therefore, the amplitude of the differential signal refers to the full peak-to-peak amplitude (i.e. clock swing) of the differential signal, which is twice the amplitude of the first clock signal or second clock signal. During testing, clock generator 110 is capable of increasing or decreasing the amplitude or clock swing of the generated differential signal, as needed, based on the output of comparator 102.

When the clock swing is at least as great as the hysteresis of comparator 102, the output of comparator 102 toggles, and counter 104 counts pulses of clk_out (e.g. counter 104 increases a count value with each rising edge or falling edge of clk_out). If the amplitude or clock swing of the differential clock signal is less than the hysteresis, the output of comparator 102 does not toggle, thus filtering out the clock swing. Therefore, during testing, clock generator 110 can generate a minimum clock swing for the differential clock signal, which is ensured to be below the hysteresis of comparator 102, and then increase the clock swing over time until the output of comparator 102 begins to toggle.

For example, in the illustrated embodiment, decision diamond 106 represents digital logic which determines whether a state change of counter 104 has been detected (which occurs upon counter 104 starting to count pulses of clk_out). Alternatively, the state change may refer to detecting a predetermined number of clock pulses of clk_out (e.g. the count value of counter 104 reaching the predetermined number). If there is no state change (or the predetermined number of clocks has not occurred), a signal is provided to clock generator 110 to increase the amplitude or clock swing of the differential clock signal. If, however, the state change has been detected at decision diamond 106, a signal is provided to clock generator 110 to log (i.e. store) the current amplitude of the differential signal. This amplitude indicates how much swing can be filtered by comparator 102 and thus corresponds to the determined (i.e. measured) hysteresis of comparator 102. Note that, in alternate embodiments, an indicator of the amplitude (or clock swing) is logged or stored rather than the amplitude itself.

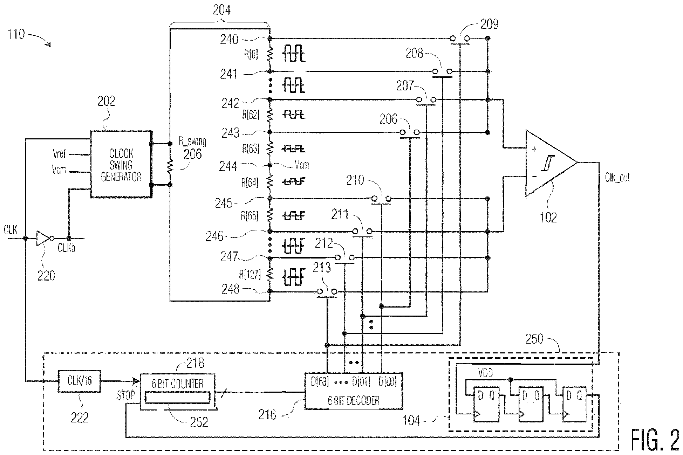

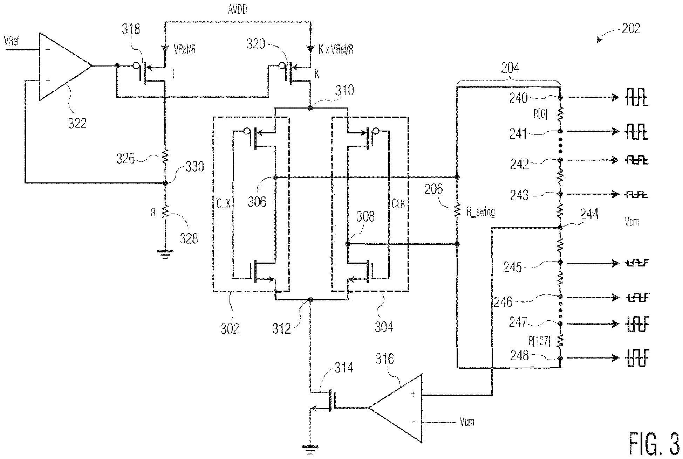

FIG. 2 illustrates, in partial block diagram and partial schematic form, a more detailed view of comparator 102 and the BIST circuitry of FIG. 1, including more detailed views of clock generator 110 and counter 104, in accordance with one embodiment of the present invention. The BIST circuitry of FIG. 2 includes digital logic 250 (also referred to as control circuitry) which includes counter 104 and control logic for varying the amplitude of the differential clock signal output by clock generator 110 based on clk_out. Note that digital logic 250 also implements the functionality of decision diamond 106 of FIG. 1. Clock generator 110 receives the input clock, CLK, which is coupled to an input of inverter 220, in which the output of inverter 220 provides the inverse of CLK as CLKb. Note that CLK can be any CMOS or digital clock or any periodic signal, and can be generated based on any type of circuitry within SoC 100. In one embodiment, CLK may be generated based on a crystal oscillator, as known in the art. Clock generator 110 includes a clock swing generator 202 coupled to each terminal of a swing resistor (R_swing) 206, at circuit nodes 240 and 248, which generates current by way of a V-to-I converter, based on a reference voltage (Vref), such that a differential clock is generated across R_swing. (Note that R_swing 206 may be considered to be part of clock swing generator 202.) Operation of clock swing generator 202 will be described in reference to FIG. 3 below. Clock generator 110 includes a resistor ladder 204 coupled to clock swing generator 202, in parallel with R_swing, between nodes 240 and 248. Circuit nodes along resistor ladder 204 provides taps corresponding to varying amplitudes with respect to a common mode voltage (Vcm) at the center of ladder 204 at a circuit node 244.

In the illustrated embodiment, ladder 204 includes 128 resistors (R[0] - R[127]), each having a same resistance R, in which 64 resistors (R[0] - R[63]) are coupled in series between node 240 and node 244 (referred to as an upper portion of the ladder) and 64 resistors (R[64] - R[127]) are coupled in series between node 244 and node 248 (referred to as a lower portion of the ladder). A circuit node corresponding to each resistor of R[0] - R[63] (e.g. circuit nodes 240-243) provides a tap to a corresponding upper clock signal which can be selected as the first clock signal of the differential clock signal to the positive input of comparator 102, and a circuit node corresponding to each resistor of R[64] - R[127] (e.g. circuit nodes 245-248) provides a tap to a corresponding lower clock signal which can be selected as the second clock signal of the differential clock signal to the negative input of comparator 102. Since each tap corresponds to a resistor of the resistor ladder, each tap may also be referred to as a resistor tap of the resistor ladder. Each resistor tap (corresponding to circuit nodes 240-243 and 245-248) are coupled via a corresponding switch (switches 209-206 and 210-213, respectively) to an input of comparator 102. For example, the circuit node corresponding to each of R[0] - R[63] is coupled via a corresponding switch to the positive input of comparator 102, and the circuit node corresponding to each of R[64] - R[127] is coupled via a corresponding switch to the negative input of comparator 102. A control electrode of each of switches 206-213 is coupled to receive a control signal from digital logic 250. When the control electrode of a switch is asserted to a logic level one, the switch is closed (i.e. on or conductive) such that the corresponding tap is connected to the corresponding input of comparator 102, and when the control electrode is negated to a logic level zero, the switch is open (i.e. off or non-conductive) thus disconnecting the corresponding tap from comparator 102. A common mode feedback is implemented for clock swing generator 202, wherein the center of the ladder at node 244 is set to the DC common mode voltage level.

Starting with tap 240, located at the top of resistor ladder 204 and connected to the first terminal of R_swing, the upper clock signal at tap 240 corresponds to the maximum amplitude of the upper clock signals. As the taps progress down towards tap 243, the amplitude (due to the increase in resistance) decreases until tap 243 which corresponds to the minimum amplitude for the upper clock signals. Similarly, starting with tap 248, located at the bottom of resistor ladder 204 and connected to the second terminal of R_swing, the lower clock signal at tap 248 corresponds to the maximum amplitude of the lower clock signals. As the taps progress up towards tap 245, the amplitude similarly decreases until tap 245 which corresponds to the minimum amplitude for the lower clock signals. Therefore, during testing, a pair of corresponding upper and lower clock signals (with corresponding matching amplitudes) is selected to provide the first and second clock signals to the positive and negative inputs comparator 102, respectively.

For example, if switches 209 and 213 are closed (and the remaining switches remain open), the upper clock signal at tap 240 is selected as the first clock signal to the positive input of comparator 102 and the lower clock signal at tap 248 is also selected as the second clock signal to the negative input of comparator 102, which together form the differential signal with the maximum amplitude across the inputs of comparator 102. If the next pair of switches 208 and 212 are instead closed, then the upper clock signal at tap 241 and the lower clock signal at tap 247 are selected as the first and second clock signals to the inputs of comparator 102, in which the amplitude of the resulting differential clock signal is less than the maximum amplitude. If switches 206 and 210 are closed, the upper clock signal at tap 243 is selected as the first clock signal and the lower clock signal at tap 245 is selected as the second clock signal, in which the amplitude of the resulting differential clock signal corresponds to the lowest or minimum amplitude across the inputs of comparator 102. Since there are 64 resistors in each of the upper and lower portions of ladder 204, the clock swing of the upper clock signal incrementally increases by 1/64 from tap 243 to tap 240. Similarly, the clock swing of the lower clock incrementally increases by 1/64 from tap 245 to tap 248. Therefore, as the pair of corresponding switches are selected from tap pair 243/245 to tap pair 240/248, the amplitude of the differential signal across the inputs of comparator 102 incrementally increases by 1/64. For example, if the maximum clock swing is 500mV, then the clock swing is incrementally increased or decreased by 7.8mV (=500mV/64) by selecting the next pair of taps immediately above or below the selected taps, respectively.

Note that the ladder 204 is an example in which, in alternate embodiments, any number of resistors may be included in the resistor ladder. The greater the number of resistors and thus taps, the finer the granularity available for increasing/decreasing the amplitude of the differential signal. The voltage change with each sequentially selected pair of taps in the upper and lower portions corresponds to a change in clock swing of the first and second clock signals (i.e. amplitude of the differential clock signal) of "max clock swing / # resistors." Note also that each resistor of FIG. 2 can be implemented with any type of resistive element and may be formed from multiple resistive elements.

In the illustrated embodiment of FIG. 2, the control signals of the switches which control the amplitude of the differential clock signal are provided by 6-bit decoder 216 which receives a 6-bit input value and provides a corresponding 64-bit output D[63:0], in which only one bit of the 64 bits is asserted to a logic level one corresponding to the 6-bit input value. For example, if the 6-bit input has a value of 0, then D[0] is asserted (and D[63:1] are all negated to logic level zeros). If the 6-bit input value has a value of 1, then D[1] is asserted (and each of D[63:2] and D[0] are negated). If the 6-bit input value has a value of 17, then D[17] is asserted, etc. Each bit output of decoder 216 is coupled to the control electrodes of a switch pair that, when closed, selects a pair of corresponding taps with matching amplitudes. For example, D[0] is coupled to the control electrodes of switches 206 and 210 (i.e. switch pair 206/210) which, when asserted, results in selecting taps 243 and 245, corresponding to the first and second clock signals with the minimum clock swing, resulting in the differential clock signal with the smallest amplitude across the inputs of comparator 102. The next output of decoder 216, D[1] is coupled to the control electrodes of switch pair 207/211 which, when asserted, results in selecting taps 242 and 246, corresponding to the first and second clock signals with an incrementally larger clock swing, resulting in the differential clock signal with an incrementally larger amplitude across the inputs of comparator 102. This continues for each output bit of decoder 216 until D[63] which is coupled to control electrodes of switch pair 209/213 such that when D[63] is asserted, the differential clock signal with the largest amplitude is provided across the inputs of comparator 102. Therefore, each increasing bit location of the output of decoder 216 (from D[0] to D[63]) corresponds to an incrementally larger amplitude of the differential clock signal provided to comparator 102.

The 6-bit decoder input is provided by 6-bit counter 218 which increments a count value 252 each time an active clock edge of a clock is received from clock divider 222 (in which the active edge can be either the rising or falling edge). Count value 252 of counter 218 can be reset to zero upon initiating testing, which is provided to decoder 216, resulting in D[0] being asserting to select taps 243 and 245 by closing switch pair 206/210. With each increment of count value 252, a next bit location of the output of decoder 216 is instead asserted (D[1], then D[2], then D[3], etc.) which selects a next pair of taps with an incrementally larger amplitude.

In operation, CLK is provided to clock swing generator 202 to generate the set of upper and lower clock signals, a pair of which can be selected as the first and second clock signals, respectively, by decoder 216 to form the differential clock signal at the input of comparator 102. CLK is also provided to clock divider 222 which divides the clock frequency of CLK by 16. (Alternate embodiments may chose to use a greater or lower divider than 16, or may not divide the clock at all.) In the illustrated example, the divided clock is provided to counter 218 which, so long as the STOP signal to counter 218 is not asserted such that counter 218 is enabled to count, continues to increment count value 252 with each active edge of the divided clock (in which the active edge may be either the rising or falling edge of the divided clock). That is, while counter 218 is enabled to count, count value 252 is incremented for every 16 pulses of CLK. During each set of 16 pulses of CLK, a currently selected pair of upper and lower clock signals are selected by decoder 216 as the first and second clock signal to the inputs of comparator 102. If the amplitude of the resulting differential signal is less than the hysteresis of comparator 102, clk_out will not toggle. Therefore, the state of counter 104 does not change. However, if the amplitude of the resulting differential signal is at least the hysteresis of comparator 102, clk_out begins to toggle (in which clk_out is first asserted to a logic level one).

In the illustrated embodiment of FIG. 2, counter 104 is implemented as three D flip flops chained in series in which a D input of each of the flip flops is coupled to receive a supply voltage, VDD, corresponding to a logic level one. A clock input of a first (i.e. beginning) flip flop is coupled to receive clk_out, a clock input of a second (i.e. middle) flip flop is coupled to receive a Q output of the first flip flop, and a clock input of a third (i.e. end) flip flop is coupled to receive the Q output of the second flip flop. A Q output of the third flip flop is provided as a stop indicator to counter 218 which, when asserted, causes counter 218 to stop counting. That is, when the stop indicator is asserted, counter 218 is disabled and count value 252 is no longer adjusted in response to the divided clock input from clock divider 222. Since counter 104 is implemented with three flip flops, the Q output of the third flip flop (and thus the stop indicator) will not be asserted until clk_out has been asserted three times (corresponding to three pulses of clk_out). In alternate embodiments, clk_out can be provided directly as the stop indicator such that counting is stopped at the first assertion of clk_out, or counter 104 may be implemented with more flip flops such that counting is stopped after a predetermined number of assertions of clk_out (which may be more or fewer than three). Note that the "state change" detected with decision diamond 106 of FIG. 1 corresponds to determining whether or not to assert the stop indicator based on the output of counter 104 (or of clk_out directly if counter 104 is not present).

In this manner, upon beginning (i.e. initiating) testing, count value 252 is reset to zero and counter 218 is enabled to count (by negating the stop indicator to a logic level zero). With count value 252 being reset to zero, the minimum amplitude is selected by decoder 216 (by closing switch pair 206/210). Since this minimum amplitude can be set or designed to be small enough so as to be ensured to be less than the hysteresis of comparator 102, clk_out will not begin to toggle. However, after 16 pulses of CLK, counter value 252 is incremented such that the next greater amplitude of the differential signal is selected by decoder 216 (by instead closing switch pair 207/211) which increments the amplitude by 1/64. If the amplitude is sufficient to cause clk_out to toggle, after three pulses of clk_out, the stop indicator is asserted which disables counter 218. However, if after 16 pulses of CLK, clk_out has not toggled, then counter value 252 is again incremented so that the next incrementally increased amplitude is selected for the differential signal. Therefore, counter 252 is continuously incremented to select an increasingly larger amplitude of the differential clock signal until clk_out sufficiently toggles to assert the stop indicator. Therefore, once counter 218 is disabled by the stop indicator, the resulting count value 252 indicates the value of the differential signal amplitude which overcame the hysteresis of comparator 102 and thus allowed clk_out to toggle. This count value indicates which of the selected upper/lower clock signals provided the sufficient clock swing to overcome the hysteresis, and from this information, the clock swing itself can be determined. For example, in the above embodiment in which the amplitude is incrementally increased by 7.8mV (500mV/64), the clock swing is provided by the count value multiplied by 7.8mV. This clock swing which resulted in clk_out toggling therefore corresponds to the determined (i.e. measured) hysteresis of comparator 102.

In one embodiment, testing performed by the BIST circuits of FIGs. 1 and 2 can be performed as needed during production or during in-field operation for in-field testing and diagnostics. In one embodiment, the BIST circuits can be triggered by a self-test control unit within the SoC, as needed. Also, although the illustrated embodiment of FIG. 2 has been described in reference to starting with a low or minimum amplitude of the differential signal at the inputs of comparator 102 and incrementally increasing the amplitude until clk_out toggles to determine the hysteresis, alternate embodiments may instead start with a higher amplitude of the differential signal and incrementally decreasing the amplitude until clk_out ceases to toggle to determine the hysteresis. Therefore, digital logic 250 can be set to incrementally adjust the amplitude by either increasing or decreasing the amplitude. For example, digital logic 250 can instead be set to have decoder 218 count down such that decoder 216 selects a pair of taps which results in incrementally decreasing the amplitude.

FIG. 3 illustrates, in schematic form, a more detailed view of clock swing generator 202, in accordance with one embodiment of the present invention. Clock swing generator 202 is coupled to a first voltage supply terminal which provides a first supply voltage, AVDD, and a second voltage supply terminal which provides a second supply voltage, GND, in which the first supply voltage is greater than second supply voltage. For ease of description, the voltage supply terminals may instead be referred to as the supply voltage they provide (e.g. AVDD and GND). Clock swing generator 202 also receives reference voltage Vref, which may also be a supply voltage. Clock swing generator 202 includes differential amplifiers 322 and 316, inverters 302 and 304, resistors 326 and 328, p-channel metal-oxide semiconductor (PMOS) transistors 318 and 320, and an n-channel metal-oxide semiconductor (NMOS) transistor 314. The ratio of sizes between transistors 318 and 320 is 1:K. An inverting input of amplifier 322 is coupled to receive Vref, a non-inverting input of amplifier 322 is coupled to a circuit node 330 located between resistors 326 and 328. An output of amplifier 322 is coupled to a control electrode of transistor 318 and to a control electrode of transistor 320. A first current electrode of transistor 318 is coupled to AVDD. Resistors 326 and 328 are coupled in series between a second current electrode of transistor 318 and GND. A first current electrode of transistor 320 is coupled to AVDD and a second current electrode of transistor 320 is coupled to a circuit node 310. A first inverter 302, implemented as a PMOS transistor in series with an NMOS transistor between node 310 and a circuit node 312, has an input coupled to receive CLK and an output coupled to a first terminal of R_swing 206 at circuit node 240. A second inverter 304, implemented as a PMOS transistor in series with an NMOS transistor between nodes 310 and 312, has an input coupled to receive CLKb and an output coupled to a second terminal of R_swing 206 at circuit node 248. A first current electrode of transistor 314 is coupled to node 312, a second current electrode of transistor 314 is coupled to GND, and a control electrode of transistor 314 is coupled to an output of amplifier 316. A non-inverting input of amplifier 316 is coupled to circuit node 244 (in the middle of ladder 204), and an inverting input of amplifier 316 is coupled to receive Vcm. In this manner, amplifier 316 controls transistor 314 to set node 244 to Vcm.

In operation, a V-to-I converter converts Vref to a corresponding current. Vref/R is provided through transistor 318 and K*Vref/R is provided through transistor 320 to node 310. Based on the values of CLK and CLKb, inverters 302 and 304 direct current through R_swing 206, which, in combination with ladder 204 generates the upper and lower clock signals which can be selected via a selected tap pair. The upper and lower signals are all provided with respect to the fixed DC Vcm voltage level at node 244, set with amplifier 316. In the embodiment of FIG. 3, it is assumed that Vref is set to 500mV, R_swing has a resistance of 500 Ohms, and a total resistance of resistors 328 and 326 is 20K Ohms (with each of resistors 328 and 326 having a resistance of 10K Ohms). Therefore, the maximum clock swing is provided as "K*Vref*R_swing/R" which is "20*500mV*5000hm/10KOhm = 500mV". In one embodiment, the total resistance value of resistor ladder 204 is 64K Ohms (128 resistors, each being 500 Ohms). In the illustrated embodiment, as was described above, with 64 resistor pairs, each selected tap pair (each selected set of upper and lower clock signals) from tap pair 243/245 to 240/248 produces a differential signal with an incremental amplitude increase of 7.8mV.

Vref can be designed, as needed, to set a desired maximum/minimum amplitudes for the differential clock signal. Also, in alternate embodiments, different circuitry may be used to generate the desired clock swings to produce the upper and lower clock signals to generate the select first and second clock signals for comparator 102. Note also, in alternate embodiments, counter 218, counter 104, and logic for generating the control signals to select pairs of taps can be implemented differently using different logic circuits and gates, as needed.

Therefore, by now it should be appreciated how a BIST circuit for a comparator can be used to determine, measure, or characterize the hysteresis of the comparator, without the need for tools external to the SoC. That is, the test sequence to determine the hysteresis can be performed with no dependency on a tester and only requires use of a digital control circuit (such as digital logic 250 of FIG. 2). For example, through the use of a counter and decoder, a pair of clock signals can be selected as first and second clock signals used as a differential clock signal at the inputs of the comparator. By selecting different pairs of clock signals, the amplitude of the differential clock signal can be incrementally adjusted (e.g. increased) to determine, at which point, the comparator stops filtering the hysteresis and allows its output to toggle. The amplitude of the differential clock signal which allowed its output to toggle therefore corresponds to the measured hysteresis of the comparator. Further, with the use of the BIST circuit, the determination of the hysteresis can be performed during production or during in-field operation. With the ability to perform the testing during in-field operation, health of the comparator can be continuously monitored to determine, for example, if the proper hysteresis is still being provided by the comparator.

The semiconductor substrate described herein can be any semiconductor material or combinations of materials, such as gallium arsenide, silicon germanium, silicon-on-insulator (SOI), silicon, monocrystalline silicon, the like, and combinations of the above.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a "b" following the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Brackets are used herein to indicate the conductors of a bus or the bit locations of a value. For example, "bus 60 [7:0]" or "conductors [7:0] of bus 60" indicates the eight lower order conductors of bus 60, and "address bits [7:0]" or "ADDRESS [7:0]" indicates the eight lower order bits of an address value. The symbol "$" preceding a number indicates that the number is represented in its hexadecimal or base sixteen form. The symbol "%" preceding a number indicates that the number is represented in its binary or base two form.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality

Also for example, in one embodiment, the illustrated elements of system 100 are circuitry located on a single integrated circuit or within a same device. Alternatively, system 100 may include any number of separate integrated circuits or separate devices interconnected with each other. Also, system 100 may be integrated within an SoC or integrated circuit with any other type of circuitry, such as processors, memories, peripherals, input/output modules, etc.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, other circuitry may be used to allow for the incremental increase of the amplitude of the differential periodic signal provided to the hysteretic comparator. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, an integrated circuit includes a comparator having a first input, a second input, and an output configured to provide an output clock; a clock generator configured to generate a differential periodic signal formed from a first periodic signal and a second periodic signal, wherein the clock generator provides the first periodic signal to the first input of the comparator and the second periodic signal to the second input of the comparator, and wherein the clock generator is configured to vary an amplitude of the differential periodic signal based on a control input; and control circuitry configured to measure hysteresis of the comparator by providing the control input to the clock generator to incrementally vary the amplitude of the differential periodic signal until detecting a predetermined number of state changes of the output clock. In one aspect of the embodiment, each of the first periodic signal, second periodic signal, and differential periodic signals are further characterized as clock signals. In another aspect, the amplitude of the differential periodic signal at which the predetermined number of state changes of the output clock is determined indicates the measured hysteresis of the comparator. In another aspect, the clock generator generates the periodic signal from an input digital clock signal. In yet another aspect, the clock generator includes a clock swing generator configured to generate the differential periodic signal over a swing resistor; and a resistor ladder (204) coupled in parallel with the swing resistor, wherein a center node of the resistor ladder corresponds to a common mode voltage, wherein the resistor ladder includes an upper portion between the center node and a first terminal of the swing resistor and a lower portion between the center node and a second terminal of the swing resistor. In a further aspect, based on the control input, the first periodic signal is selected from a tap in the upper portion of the resistor ladder and the second periodic signal is selected from a tap in the lower portion, wherein each of the first periodic signal and second periodic signal are generated about the common mode voltage to form the differential periodic signal at the inputs of the comparator. In another further aspect, the upper portion includes a plurality of tap points, each corresponding to a resistor in the upper portion of the resistor ladder, wherein each tap point of the plurality of tap points in the upper portion generates an upper periodic signal selectable as the first periodic signal, and the lower portion includes a plurality of tap points, each corresponding to a resistor in the lower portion of the resistor ladder, wherein each tap point of the plurality of tap points in the lower portion generates a lower periodic signal selectable as the second periodic signal. In yet a further aspect, each tap of the plurality of taps in the upper portion is coupled via an upper switch to the first input of the comparator and each tap of the plurality of taps in the lower portion is coupled via a lower switch to the second input of the comparator, wherein the upper and lower switches form switch pairs, each containing one upper switch and one lower switch such that each switch of the upper portion forms a switch pair with a corresponding switch of the lower portion. In yet an even further aspect, the control input provides a set of control bits including a control bit to each switch pair, wherein the control circuitry asserts one control bit of the set of control bits to select both a selected tap in the upper portion to generate the first periodic signal and a selected tap in the lower portion to generate the second periodic signal. In yet an even further aspect, the clock generator generates the periodic signal from an input clock signal, and wherein the control circuitry includes a first counter configured to count an active edge of a divided clock generated from the input clock signal; and a decoder coupled to receive a count value from the first counter and configured to assert one control bit of the set of control bits in response to the count value from the first counter. In yet an even further aspect, the integrated circuit further includes a second counter configured to count active edges of the output clock, wherein the second counter is further configured to disable the first counter when a count value of the second counter indicates the predetermined number of state changes of the output clock has occurred.

In another embodiment, a method for performing a built-in self test (BIST) of a comparator within an integrated circuit includes generating a first clock signal for a positive input of the comparator and a second clock signal for a negative input of the comparator, wherein the second clock signal is a same clock signal as the first clock signal but shifted 180 degrees with respect to the first clock signal so as to form a differential clock signal at the inputs of the comparator; incrementally adjusting an amplitude of the differential clock signal provided to the inputs of the comparator while monitoring an output clock at an output of the comparator; stopping the incrementally adjusting of the amplitude when a predetermined number of active edges of the output clock has been detected; and determining a hysteresis voltage of the comparator based on the amplitude of the differential clock signal when the incrementally adjusting is stopped. In one aspect of the another embodiment, the incrementally adjusting the amplitude of the differential clock signal includes setting the amplitude to a minimum amplitude of the differential clock signal; and incrementally increasing the amplitude of the differential clock signal while monitoring the output clock. In a further aspect, the first and second clock signals are generated based on an input clock, and the method further includes, each time the amplitude is increased, maintaining the amplitude for a predetermined number of pulses of the input clock to observe the clock output. In another aspect of the another embodiment, the incrementally adjusting the amplitude of the differential clock signal includes using a clock swing generator and resistor ladder to generate a plurality of upper clock signals from resistor taps in an upper portion of the resistor ladder and a plurality of lower clock signals from resistor taps in a lower portion of the resistor ladder, wherein a center node between the upper and lower portions of the resistor ladder is set to a common mode voltage; and, with each incremental adjustment of the amplitude, selecting adjacent resistor taps to a current resistor tap in the upper portion of the resistor ladder and a current resistor tap in the lower portion of the resistor ladder, wherein the selected adjacent resistor tap in upper portion provides the first clock signal to the positive input and the selected adjacent resistor tap in the lower portion generates the second clock signal to the negative input. In a further aspect, the selected adjacent resistor taps provide an incrementally larger amplitude for the differential signal as compared to the current resistor taps.

In yet another embodiment, an integrated circuit includes a comparator having a first input configured to receive a first clock signal, a second input configured to receive a second clock signal, and an output configured to provide an output clock; a clock swing generator configured to generate a differential clock signal over a swing resistor from an input clock signal; and a resistor ladder coupled in parallel with the swing resistor, wherein a center node of the resistor ladder corresponds to a common mode voltage, wherein the resistor ladder includes an upper portion between the center node and a first terminal of the swing resistor and a lower portion between the center node and a second terminal of the swing resistor, wherein the upper portion includes a plurality of upper taps, each corresponding to a resistor in the upper portion of the resistor ladder, wherein each upper tap of the plurality of upper taps generates an upper clock signal selectable as the first clock signal, and the lower portion includes a plurality of lower taps, each corresponding to a resistor in the lower portion of the resistor ladder, wherein each lower tap of the plurality of lower taps generates a lower clock signal selectable as the second clock signal; and control circuitry configured to monitor the output clock and provide a set of control bits, based on the output clock, to select a pair of taps, including an upper tap and a lower tap such that the upper tap provides the first clock signal to the first input of the comparator and the lower tap provides the second clock signal to the second input of the comparator. In one aspect of the yet another embodiment, each of the first and second clock signals are generated about the common mode voltage to form the differential signal at the inputs of the comparator, wherein each upper tap is paired with a corresponding lower tap to result in a selectable differential signal, each selectable differential signal having a different amplitude. In a further aspect, the control circuitry includes a first counter configured to count an active edge of a divided clock generated from the input clock signal; and a decoder coupled to receive a count value from the first counter and configured to assert one control bit of the set of control bits in response to the count value from the first counter to select the pair of taps. In yet a further aspect, the control circuitry further includes a second counter configured to count active edges of the monitored output clock, wherein the second counter is further configured to disable the first counter when a count value of the second counter indicates a predetermined number of active edges of the monitored output clock has occurred.

## Claims

1. An integrated circuit, comprising:
a comparator having a first input, a second input, and an output configured to provide an output clock;
a clock generator configured to generate a differential periodic signal formed from a first periodic signal and a second periodic signal, wherein the clock generator provides the first periodic signal to the first input of the comparator and the second periodic signal to the second input of the comparator, and wherein the clock generator is configured to vary an amplitude of the differential periodic signal based on a control input; and
control circuitry configured to measure hysteresis of the comparator by providing the control input to the clock generator to incrementally vary the amplitude of the differential periodic signal until detecting a predetermined number of state changes of the output clock.

2. The integrated circuit of claim 1, wherein each of the first periodic signal, second periodic signal, and differential periodic signals are further characterized as clock signals.

3. The integrated circuit of claim 1 or 2, wherein the amplitude of the differential periodic signal at which the predetermined number of state changes of the output clock is determined indicates the measured hysteresis of the comparator.

4. The integrated circuit of any preceding claim, wherein the clock generator generates the periodic signal from an input digital clock signal.

5. The integrated circuit of any preceding claim, wherein the clock generator comprises:
a clock swing generator configured to generate the differential periodic signal over a swing resistor; and
a resistor ladder coupled in parallel with the swing resistor, wherein a center node of the resistor ladder corresponds to a common mode voltage, wherein the resistor ladder includes an upper portion between the center node and a first terminal of the swing resistor and a lower portion between the center node and a second terminal of the swing resistor.

6. The integrated circuit of claim 5, wherein, based on the control input, the first periodic signal is selected from a tap in the upper portion of the resistor ladder and the second periodic signal is selected from a tap in the lower portion, wherein each of the first periodic signal and second periodic signal are generated about the common mode voltage to form the differential periodic signal at the inputs of the comparator.

7. The integrated circuit of claim 5 or 6, wherein:
the upper portion includes a plurality of tap points, each corresponding to a resistor in the upper portion of the resistor ladder, wherein each tap point of the plurality of tap points in the upper portion generates an upper periodic signal selectable as the first periodic signal, and
the lower portion includes a plurality of tap points, each corresponding to a resistor in the lower portion of the resistor ladder, wherein each tap point of the plurality of tap points in the lower portion generates a lower periodic signal selectable as the second periodic signal.

8. The integrated circuit of claim 7, wherein each tap of the plurality of taps in the upper portion is coupled via an upper switch to the first input of the comparator and each tap of the plurality of taps in the lower portion is coupled via a lower switch to the second input of the comparator, wherein the upper and lower switches form switch pairs, each containing one upper switch and one lower switch such that each switch of the upper portion forms a switch pair with a corresponding switch of the lower portion.

9. The integrated circuit of claim 8, wherein the control input provides a set of control bits including a control bit to each switch pair, wherein the control circuitry asserts one control bit of the set of control bits to select both a selected tap in the upper portion to generate the first periodic signal and a selected tap in the lower portion to generate the second periodic signal.

10. The integrated circuit of claim 9, wherein the clock generator generates the periodic signal from an input clock signal, and wherein the control circuitry comprises:
a first counter configured to count an active edge of a divided clock generated from the input clock signal; and
a decoder coupled to receive a count value from the first counter and configured to assert one control bit of the set of control bits in response to the count value from the first counter.

11. The integrated circuit of claim 10, further comprising a second counter configured to count active edges of the output clock, wherein the second counter is further configured to disable the first counter when a count value of the second counter indicates the predetermined number of state changes of the output clock has occurred.

12. A method for performing a built-in self test (BIST) of a comparator within an integrated circuit, the method comprising:
generating a first clock signal for a positive input of the comparator and a second clock signal for a negative input of the comparator, wherein the second clock signal is a same clock signal as the first clock signal but shifted 180 degrees with respect to the first clock signal so as to form a differential clock signal at the inputs of the comparator;
incrementally adjusting an amplitude of the differential clock signal provided to the inputs of the comparator while monitoring an output clock at an output of the comparator;
stopping the incrementally adjusting of the amplitude when a predetermined number of active edges of the output clock has been detected; and
determining a hysteresis voltage of the comparator based on the amplitude of the differential clock signal when the incrementally adjusting is stopped.

13. The method of claim 12, wherein the incrementally adjusting the amplitude of the differential clock signal comprises:
setting the amplitude to a minimum amplitude of the differential clock signal; and
incrementally increasing the amplitude of the differential clock signal while monitoring the output clock.

14. The method of claim 13, wherein the first and second clock signals are generated based on an input clock, the method further comprising:
each time the amplitude is increased, maintaining the amplitude for a predetermined number of pulses of the input clock to observe the clock output.

15. The method of any of claims 12 to 14, wherein the incrementally adjusting the amplitude of the differential clock signal comprises:
using a clock swing generator and resistor ladder to generate a plurality of upper clock signals from resistor taps in an upper portion of the resistor ladder and a plurality of lower clock signals from resistor taps in a lower portion of the resistor ladder, wherein a center node between the upper and lower portions of the resistor ladder is set to a common mode voltage; and
with each incremental adjustment of the amplitude, selecting adjacent resistor taps to a current resistor tap in the upper portion of the resistor ladder and a current resistor tap in the lower portion of the resistor ladder, wherein the selected adjacent resistor tap in upper portion provides the first clock signal to the positive input and the selected adjacent resistor tap in the lower portion generates the second clock signal to the negative input.
